# FASCICULE DE BREVET EUROPEEN

(11) **EP 3 376 545 B1**
(45) Date de publication et mention de la délivrance du brevet: **29.06.2022**
(21) Numéro de dépôt: 18161268.0
(22) Date de dépôt: 12.03.2018
(51) Int. Cl.: H01L 21/336, H01L 29/78, H01L 29/786, H01L 27/12, H01L 29/08

(54) **TRANSISTOR A REGIONS SOURCE ET DRAIN STRUCTUREES ET SON PROCEDE D'ELABORATION**
TRANSISTOR MIT STRUKTURIERTEN SOURCE- UND DRAIN-BEREICHEN, UND SEIN BEARBEITUNGSVERFAHREN
TRANSISTOR WITH STRUCTURED SOURCE AND DRAIN REGIONS AND METHOD FOR PRODUCING SAME

(30) Priorité: 13.03.2017 FR 1752035
(43) Date de publication de la demande: 19.09.2018
(73) Titulaire: Commissariat à l'énergie atomique et aux énergies alternatives, 75015 Paris (FR)
(72) Inventeur: MAZZOCCHI, Vincent, 38000 GRENOBLE (FR); GRENOUILLET, Laurent, 38640 CLAIX (FR)
(74) Mandataire: Brevalex

(56) Documents cités:
- US-A- 5 953 605
- US-A1- 2016 247 888
- AOYAMA T ET AL: "Facet formation mechanism of silicon selective epitaxial layer by Si ultrahigh vacuum chemical vapor deposition", JOURNAL OF CRYSTAL GROWTH, ELSEVIER, AMSTERDAM, NL, vol. 136, no. 1-4, 1 mars 1994 (1994-03-01), pages 349-354, XP024473929, ISSN: 0022-0248, DOI: 10.1016/0022-0248(94)90438-3 [extrait le 1994-03-01]

## Description

### DOMAINE TECHNIQUE ET ÉTAT DE LA TECHNIQUE ANTÉRIEURE

La présente invention se rapporte à un transistor à effet de champ avec des régions de source et de drain surélevées et structurées. La présente invention se rapporte également à un procédé d'élaboration d'une structure cristalline facettée, notamment, pour former les régions de source et de drain surélevées d'un transistor.

La figure la est une vue en coupe transversale schématique d'un transistor à effet de champ de type MOS (pour « Metal Oxide Semiconductor ») classique.

Le transistor comprend un substrat 100, par exemple en silicium sur isolant (SOI). Le transistor comporte une grille 101 électriquement conductrice isolée de la surface du substrat 100 par un isolant de grille 102. Des espaceurs 103 entourent la grille 101 et reposent sur le substrat 100. Des régions de source et drain surélevés 104a, 104b (RSD pour « Raised Source/Drain ») s'étendent à partir du substrat 100 de part et d'autre de la grille 101. Les régions de source et drain surélevés 104a, 104b sont en matériau semi-conducteur cristallin, dopées n si le transistor est à canal n. Des zones dites extensions 105a, 105b des régions source/drain s'étendent sous la grille du transistor. Ces zones sont des zones diffusées de type n- (moins dopées que les régions source/drain).

Le transistor de la figure la comprend également deux couches 106a, 106b recouvrant les régions source/drain 104a, 104b. Ces zones 106a, 106b sont en siliciure métallique et forment les métallisations de la source et du drain du transistor. Ces métallisations ne doivent pas être en contact avec le canal 107 pour éviter la siliciuration du canal.

Les propriétés électriques des transistors MOS sont limitées par diverses capacités : capacité de contact entre la grille 101 et les contacts déposés sur les métallisations des régions de source/drain 104a, 104b, capacité entre la grille 101 et les régions source/drain 104a, 104b via les espaceurs 103 (appelée « capacitance out of fringe »), capacité de recouvrement direct entre la grille 101 et les extensions 105a, 105b des régions de source/drain 104a, 104b (« capacitance of direct overlap »).

Pour réduire la capacité entre la grille 101 et les régions source/drain surélevées 104a, 104b une première solution consiste à diminuer l'épaisseur des régions source/drain 104a, 104b. Cependant, une diminution de l'épaisseur des régions source/drain 104a, 104b conduit à une diminution du nombre de dopants pouvant diffuser dans le canal 107 et sous les espaceurs 103. Une épaisseur trop faible pourrait également conduire à une forte siliciuration des régions source/drain.

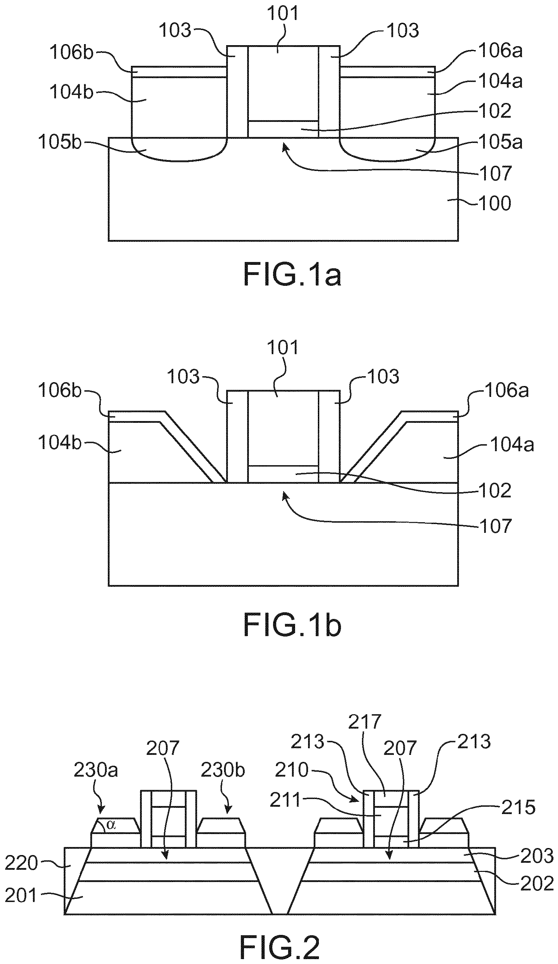

Comme représenté sur la figure 1b, une autre solution pour diminuer cette capacité parasite consiste à réaliser des régions source/drain facettées 104a, 104b pour éloigner les régions source/drain des espaceurs 103 (Grenouillet et al. UTBB FDSOI scaling enablers for the 10 nm node, IEEE SOI-3D-subthreshold microelectronics technology unified conférence (S3S), 2013). Cependant, lorsque les régions source/drain 104a, 104b sont éloignées des espaceurs 103, il y a un risque de siliciuration du canal 107 lors de la formation de la métallisation 106a, 106b. De plus, suite à la gravure, l'espaceur peut présenter, au niveau de son pied, quelques fluctuations d'épaisseur, conduisant à des variations au niveau des performances électriques (à travers la diffusion des dopants), notamment dans le cas des régions source/drain facettées, et donc à des fluctuations importantes aléatoires dans les performances des transistors.

Le document US 2016/0247888 A1 décrit également un transistor avec des régions source/drain facettées.

### EXPOSÉ DE L'INVENTION

C'est par conséquent un but de la présente invention d'offrir un transistor avec des capacités parasites plus faibles que les transistors de l'art antérieur et présentant de bonnes performances.

Pour cela, la présente invention propose un transistor à effet de champ, selon la revendication 1.

Les régions de source et de drain facettées permettent, non seulement de diminuer les capacités parasites, mais en plus elles protègent le canal du transistor des métallisations des régions de source et de drain.

Selon l'invention, la face principale supérieure de la première couche est entièrement recouverte et en contact avec la première face principale de la seconde couche.

Cette configuration permet de réduire les résistances d'accès au canal, notamment par rapport à un dispositif dans lequel la face principale supérieure de la première couche serait partiellement recouverte d'un espaceur isolant.

En maximisant la surface de contact entre la face supérieure de la première couche et la première face principale de la deuxième couche, on peut également induire une contrainte plus importante sur la région de canal en particulier lorsque les régions de source et de drain sont à base d'un second matériau semi-conducteur cristallin ayant un paramètre de maille différent de celui du premier matériau semi-conducteur cristallin.

Une telle configuration permet de conférer à la deuxième couche une surface externe (surface cumulée de sa deuxième face principale et de ses faces latérales qui n'est pas en contact avec la première couche) pour former un contact amélioré sur la deuxième couche.

De manière avantageuse, la première couche a une épaisseur comprise entre 2nm et 5 nm, et de préférence entre 2nm et 3nm. De telles épaisseurs permettent d'avoir une structure avec des facettes qui commencent bas, à proximité du canal, et donc de limiter efficacement les capacités parasites.

De manière avantageuse, la seconde couche a une épaisseur comprise entre 5nm et 50 nm, de préférence entre 5nm et 20nm.

Avantageusement, la seconde face principale de la seconde couche a une longueur supérieure à 10nm et inférieure à 1000nm, et de préférence de 20nm à 50nm. Cette longueur permet une bonne prise de contact sur les régions de source et de drain, tout en étant suffisamment faible pour limiter la résistance d'accès.

De manière avantageuse, le premier matériau semi-conducteur cristallin est du Si ou du SiGe et le second matériau semi-conducteur cristallin est du SiGe.

Avantageusement, la première couche est dopée avec un dopant et a une concentration en dopant supérieure ou égale à 7.10¹⁹ at/cm³.

Avantageusement, la seconde couche est dopée avec un dopant et a une concentration en dopant supérieure ou égale à 2.10²⁰ at/cm³. Ceci permet d'assurer un bon contact sur la partie supérieure de la région source/drain.

La concentration en dopant de la première couche peut être identique ou différente de la concentration en dopant de la seconde couche.

De manière avantageuse, la structure cristalline facettée formant la région de source et/ou la région de drain est exempte de défaut. Le transistor est plus performant.

Avantageusement, la structure cristalline facettée est recouverte d'une couche de siliciure, le canal étant isolé de la couche de siliciure par la structure cristalline facettée.

Il existe également un besoin pour réaliser des régions de source et de drain structurées. L'invention a également pour but un procédé de réalisation d'une structure cristalline facettée facile à mettre en œuvre. Ce but est atteint par un procédé comprenant les étapes selon la revendication 7.

Selon l'invention, la face principale supérieure de la première couche est entièrement recouverte par, et est en contact avec, la seconde couche.

Cela peut permettre de diminuer les résistances d'accès au canal, éventuellement d'augmenter la contrainte induite sur la région de canal, et de conférer à la deuxième couche une surface externe plus importante pour pouvoir réaliser par-dessus des contacts.

Le procédé permet de réaliser des structures cristallines complexes en utilisant uniquement des étapes d'épitaxies.

De manière avantageuse, le mélange de réactifs de la première épitaxie comprend au moins un précurseur chloré du second matériau semi-conducteur.

De manière avantageuse, le mélange de réactifs de la seconde épitaxie comprend au moins un précurseur hydrogéné du second matériau semi-conducteur.

Avantageusement, le premier matériau semi-conducteur cristallin est du Si ou du SiGe et le second matériau semi-conducteur cristallin est du SiGe.

Avantageusement, le mélange de réactifs de la première épitaxie comprend du dichlorosilane, du germane, de l'acide chlorhydrique et, éventuellement, du diborane.

Avantageusement, le mélange de réactifs de la seconde épitaxie comprend du silane, du germane, de l'acide chlorhydrique et, éventuellement, du diborane.

Avantageusement, le mélange de réactifs de la seconde épitaxie comprend en outre un composé additionnel choisi parmi le dichlorosilane ou un composé de formule SiₙH₂ₙ₊₂ avec n>1, le composé additionnel représentant au maximum 15% volumique par rapport au volume total formé par le silane et le composé additionnel.

De manière avantageuse, les épitaxies sont réalisées à une température inférieure à 700°C, et de manière encore plus avantageuse à une température allant de 575°C à 675°C.

Le procédé est, avantageusement, utilisé pour former les régions de source et de drain d'un transistor à effet de champ, tel qu'un transistor FDSOI, et plus particulièrement un transistor pMOS.

Avantageusement, la première couche et la deuxième couche sont réalisées par épitaxies successives sans étape de dépôt ou de gravure intermédiaire.

Avantageusement, la première couche et la deuxième couche sont réalisées par épitaxies successives dans un même réacteur (ou dans un même équipement) et sans sortir le substrat dudit réacteur (respectivement dudit équipement).

### BRÈVE DESCRIPTION DES DESSINS

D'autres caractéristiques et avantages de l'invention ressortiront mieux de la description qui va suivre et des dessins annexés dans lesquels:
- la figure 1a, déjà commentée ci-dessus, est une vue partielle, en coupe et de profil, d'un transistor selon l'art antérieur,
- la figure 1b est une vue partielle, en coupe et de profil, d'un transistor dont les métallisations des régions de source et de drain sont en contact avec le canal,
- la figure 2 représente une vue partielle, en coupe et de profil, d'un transistor selon un premier mode de réalisation de l'invention,
- la figure 3 représente une vue partielle, en coupe et de profil, d'un transistor selon un deuxième mode de réalisation de l'invention,
- la figure 4 représente une vue partielle, en coupe et de profil, d'un transistor selon un troisième mode de réalisation de l'invention,
- la figure 5 représente une vue partielle, en coupe et de profil, d'une structure cristalline facettée sur un substrat selon un mode particulier de réalisation de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et pouvant se combiner entre elles.

### EXPOSÉ DÉTAILLÉ DE MODES DE RÉALISATION PARTICULIERS

### Transistor à effet de champ :

On se réfère à la figure 2 qui représente une vue partielle d'un transistor à effet de champ, en coupe et de profil.

Le transistor est réalisé sur un substrat 200 en matériau semi-conducteur cristallin.

Selon un mode de réalisation préférentiel, représenté sur les figures 2 à 4, le transistor est un transistor FDSOI (« Fully Depleted Silicon On Insulator » en langue anglaise), c'est-à-dire un transistor complètement déserté de type silicium sur isolant. Le substrat SOI 200 comprend un support de base en matériau semi-conducteur 201, une couche isolante 202 et une fine couche en matériau semi-conducteur cristallin 203 dite couche superficielle. La couche isolante 202 est disposée entre la couche de support 201 et la couche superficielle 203. La couche isolante 201 permet, en particulier, d'éviter des courants parasites vers la partie massive du substrat et permet de mieux isoler les régions de source et de drain. La couche isolante 202 peut être en particulier une couche de type BOX (BOX pour « Burried Oxide ») ou TBOX (TBOX pour « Thin Burried Oxide») d'épaisseur allant de 10nm à 200nm, par exemple de l'ordre 20 nm. La fine couche semi-conductrice superficielle 203 a une épaisseur comprise, par exemple, entre 2nm et 200nm, par exemple de l'ordre 6 nm

La couche mince superficielle 203 est, préférentiellement, en silicium cristallin ou en SiGe cristallin. Le matériau SiGe présente, avantageusement, une concentration de 10 à 40% atomique de germanium, et de manière encore plus avantageuse de 15% à 35% atomique, par exemple de l'ordre de 25% atomique. Selon une variante, la couche mince superficielle 203 du substrat 200 pourrait être, par exemple, en un matériau III-V.

La région de canal 207 du transistor est formée dans la couche mince superficielle 203 du substrat 200. La région de canal 207 est surmontée d'une structure de grille 210, la structure de grille 210 comprenant une grille 211 et des espaceurs 213 électriquement isolants tapissant ses flancs.

La grille 211 du transistor peut être formée d'un empilement comprenant une couche métallique, par exemple à base de TiN, sur laquelle repose une couche semi-conductrice, par exemple à base de polysilicium.

La grille 211 est séparée du substrat 200 par un matériau électriquement isolant, appelé isolant de grille 215. Le matériau électriquement isolant est par exemple formé d'une couche d'oxyde, appelée aussi oxyde de grille, et d'une couche de matériau diélectrique, qui peut être un métal de grille choisi en fonction du choix de la tension de seuil. La couche d'oxyde est en contact avec le substrat. Il s'agit, par exemple, de HfO₂ ou de HfSiON.

Des espaceurs 213 isolants, appelés aussi régions latérales d'isolation, sont formés contre les flancs latéraux de la grille 211, et reposent sur le substrat 200 semi-conducteur. Les espaceurs 213 sont formés d'un ou plusieurs matériaux électriquement isolants, par exemple à base de SiₓN_{y}, de SiBCN, de SiCO ou de SiOCN. Les espaceurs 213 ont, de manière avantageuse, une épaisseur allant de 4nm à 12nm, et, de manière encore plus avantageuse, une épaisseur allant de 6nm à 8nm. Les espaceurs 213 servent à éloigner les régions source/drain de la grille 211 et de la région de canal 207.

La grille 211 peut également être recouverte d'un masque dur 217 en matériau électriquement isolant, en oxyde ou en nitrure par exemple, en particulier lorsque la dernière couche est en silicium polycristallin afin de ne pas la consommer lors des différentes étapes de gravure.

La fabrication de la structure de grille 211 a lieu selon des procédés de microélectronique bien connus de l'homme du métier et ne sera pas décrite ici.

Comme représenté sur la figure 2, les transistors d'une même couche peuvent être isolés les uns des autres par des tranchées latérales d'isolation 220 (ou STI pour« Shallow Trench Isolation »).

### Régions de source/drain surélevées du transistor :

Une région de source 230a et une région de drain 230b, en matériau semi-conducteur cristallin, sont situées de part et d'autre des espaceurs 213 isolants, et en contact direct avec le matériau semi-conducteur de la couche mince superficielle 203.

L'emplacement des régions de source 230a et de drain 230b pourrait être inversé.

Les régions de source 230a et de drain 230b sont en matériau IV-IV. Elles pourraient aussi être, par exemple, en matériau III-V. Préférentiellement, les régions 230a et de drain 230b sont en SiGe. Il est possible de réaliser des sources et drains 230a, 230b surélevés avec des matériaux différents de celui du canal, afin d'augmenter la contrainte dans le canal. Du SiGe, peut être utilisé pour un transistor pMOS pour induire une contrainte en compression sur la zone du canal, par exemple, en silicium.

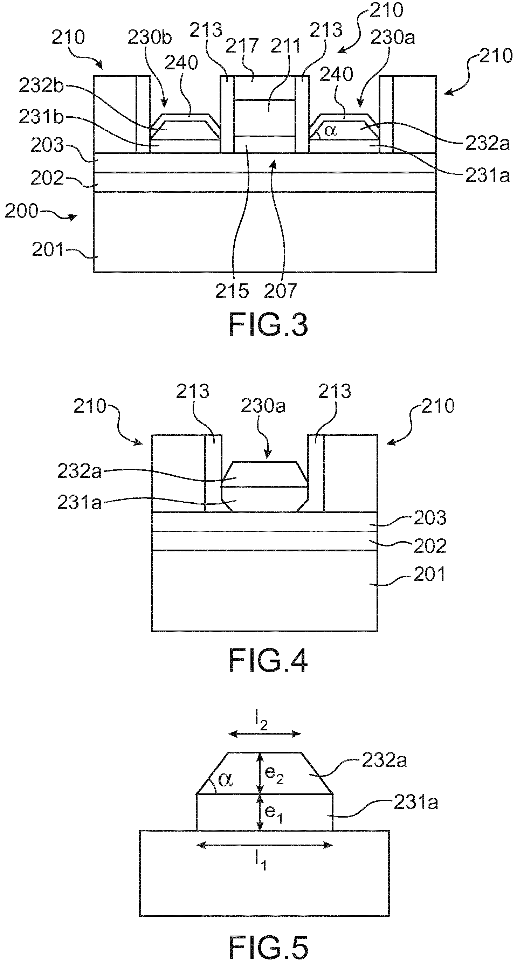

Comme représenté sur la figure 3, une région de source/drain 230a, 230b surélevée peut être positionnée entre deux structures de grille 210.

Comme représenté sur les figures 2 à 5, la région de source 230a et la région de drain 230b sont, chacune, formées d'une structure cristalline facettée formée d'un empilement bicouche. L'empilement comprend et, est de préférence, constitué par :
- une première couche 231a, 231b en contact avec le substrat 200, et plus particulièrement avec la couche mince superficielle 203, la première couche 231a, 231b comprenant deux faces principales parallèles entre elles et deux faces latérales parallèles entre elles, les faces principales étant perpendiculaires aux faces latérales, une des faces latérales étant en contact avec un des espaceurs 213,
- une seconde couche 232a, 232b recouvrant la première couche 231a, 231b, la seconde couche 232a, 232b comprenant deux faces principales parallèles entre elles et deux faces latérales, une des faces principales étant en contact avec la première couche 231a, 231b, les faces latérales formant un angle α de 50° à 59°, et de préférence de 53°, avec la face principale en contact avec la première couche 231a, 231b.

Une telle structure minimise la capacité entre la grille et les régions source/drain, du fait de la présence de facette sur la couche supérieure de l'empilement.

Cette structure évite également les problèmes de siliciuration du canal lors de la métallisation des régions source/drain 230a, 230b. Comme la première couche 231a, 231b est en contact avec le flanc des espaceurs 213, il n'y aura pas de siliciuration du canal, autrement dit, il n'y aura pas de contamination du canal avec le siliciure 240 (figure 3).

Selon une configuration avantageuse illustrée des régions de sources et de drain 230a, 230b la première couche 231a, 231b comporte une face supérieure qui est en contact avec la seconde couche 232a, 232b et est entièrement recouverte par la seconde couche 232a, 232b. Cette configuration, où le matériau semi-conducteur de la première couche 231a, 231b est seulement recouvert par le matériau semi-conducteur de la seconde couche 232a, 232b et n'est en particulier pas recouvert par un matériau isolant permet d'avoir réduire des résistances d'accès au canal réduites, en comparaison en particulier avec une structure à doubles espaceurs isolants et dans laquelle une deuxième paire d'espaceurs formée contre une première paire d'espaceurs, viendrait reposer en partie sur la première couche 213a, 231b.

La figure 5 représente une région de source structurée 230a. Il aurait pu s'agir de la région de drain 230b qui présente la même architecture. La première couche 231a a une épaisseur e₁ comprise entre 2nm et 5 nm, de préférence, entre 2nm et 3nm. L'épaisseur e₁ de la première couche 231a détermine la hauteur à laquelle commence la facette de la structure cristalline 230a.

La seconde couche 232a a une épaisseur e₂ comprise entre 5nm et 50nm, de préférence entre 5nm et 20nm.

La longueur I₂ de la seconde face de la seconde couche 232a dépend de l'épaisseur e₂ choisie, puisque l'angle α entre les parois latérales et la première face est fixe. Cette longueur I₂ doit être suffisante pour permettre une prise de contact sur les régions de source/drain 230a. Elle doit, en même temps, ne pas être trop élevée pour limiter la résistance d'accès qui est inversement proportionnelle à la surface de siliciure 240 déposée sur les régions source/drain 230a. La surface de siliciure déposé dépend également de la surface des régions source/drain qui est accessible lors de la siliciuration. De manière avantageuse, on choisira une longueur I₂ supérieure à 10nm. Avantageusement, elle sera inférieure à 1000nm, et de préférence de l'ordre de 20nm à 50nm.

L'épaisseur e₂ de la seconde couche 232a sera choisie de manière à permettre une prise de contact sur la seconde couche 232a tout en limitant la résistance d'accès.

Dans le cas d'une structure cristalline en SiGe, la concentration en germanium de la première couche 231a, 231b et/ou de la seconde couche 232a, 232b peut être constante, croissante ou décroissante, perpendiculairement à l'épaisseur e₁, e₂ des couches.

### Procédé de réalisation des régions de source/drain surélevées :

Bien que le procédé fasse explicitement référence à un transistor, il peut être mis en œuvre pour la fabrication concomitante d'une pluralité de transistors.

D'une manière générale, il est mis en œuvre pour la réalisation de tout élément en matériau semi-conducteur cristallin dont la structure doit être facettée et dont la croissance peut être réalisée à partir d'un substrat adapté.

Il a été constaté que ce procédé fonctionnait particulièrement bien pour réaliser des structures cristallines facettées en SiGe.

Pour réaliser les régions de source et drain surélevées du transistor, et leur donner une structure facettée, on fait croître le matériau semi-conducteur cristallin à partir du substrat à travers deux épitaxies successives. La première épitaxie est réalisée en présence d'un mélange de réactifs tel qu'il permet une croissance cristalline du matériau semi-conducteur selon le plan 100. La seconde épitaxie est réalisée en présence d'un mélange de réactifs tel qu'il permet une croissance cristalline du matériau semi-conducteur selon le plan 111.

Préférentiellement, le mélange de réactifs de la première épitaxie comprend au moins un précurseur chloré du matériau semi-conducteur à faire croitre et le mélange de réactifs de la seconde épitaxie comprend au moins un précurseur hydrogéné du matériau semi-conducteur à faire croitre.

### Epitaxie en milieu chloré :

Lors d'une épitaxie en chimie chlorée, le dépôt cristallin croît sur les zones du transistor qui sont en matériau semi-conducteur cristallin. Il n'y a pas de dépôt sur les autres zones telles que les zones d'isolation, en matériau diélectrique (oxyde ou nitrure) ou encore sur les zones en matériau semi-conducteur non cristallin. L'utilisation d'une chimie chlorée conduit à une croissance sélective. Dans le cas du SiGe, les nucleii de poly-SiGe qui se forment sur les zones recouvertes de matériau diélectrique vont être gravés au fur et à mesure de leur formation, conduisant au final à une augmentation de l'épaisseur de la région en matériau semi-cristallin uniquement selon l'orientation (100).

Dans le cas de la formation de régions source/drain en SiGe, l'épitaxie sélective en chimie chlorée est réalisée avec un mélange de réactifs comprenant du dichlorosilane SiH₂Cl₂ (DCS), du germane GeH₄ et de l'acide chlorhydrique HCl et, éventuellement, avec du diborane B₂H₆ pour doper le SiGe in situ. Selon une variante, du dichlorogermane pourrait être utilisé.

Selon une autre variante, du silane pourrait éventuellement être présent dans le mélange, le rapport massique silane/dichlorosilane ne dépassant pas 10%.

De préférence, le mélange de réactifs est constitué par du dichlorosilane SiH₂Cl₂, du germane GeH₄, de l'acide chlorhydrique HCl et du diborane B₂H₆.

Le gaz utilisé pour le transport des réactifs est, de préférence, du dihdrogène. Selon une variante, de l'azote pourrait être utilisé.

L'épitaxie en chimie chlorée est, avantageusement, réalisée à une température allant de 500°C à 700°C, et de préférence à une température allant de 500°C à 650°C.

De manière avantageuse, représentée à la figure 4, même si l'espaceur 213 présente un décochement aussi appelé pied, la première couche épitaxiée 231a de la structure cristalline 230 le recouvrira.

### Epitaxie en milieu hydrogéné :

L'utilisation de silane peut conduire à une épitaxie moins sélective. On parle également d'épitaxie non sélective associée à une gravure sélective. Une telle épitaxie consiste à déposer de manière non sélective sur la totalité de la surface du substrat des couches monocristalline ou polycristalline. Dans le cas du SiGe, on utilise le fait que l'acide chlorhydrique grave le poly-SiGe beaucoup plus rapidement que le SiGe monocristallin afin de retirer le matériau polycristallin sur les zones diélectriques. Ce type de procédé peut être cyclé.

Il est également possible de réaliser un dépôt sélectif lorsque les précurseurs, par exemple du SiGe, sont introduits en même temps que l'acide chlorhydrique (épitaxie dite « co-flow »).

L'épitaxie hydrogénée conduit à une croissance latérale plus limitée qu'en chimie chlorée, et donc à la formation de facettes selon l'orientation (111).

Préférentiellement, l'épitaxie sélective en chimie hydrogénée est réalisée avec un mélange de réactifs comprenant :
- un premier précurseur du silicium : du silane SiH₄,
- du germane GeH₄,
- de l'acide chlorhydrique HCl,
- et, éventuellement, du diborane B₂H₆ pour doper le SiGe in situ.

Avantageusement, on utilise le fait que l'acide chlorhydrique grave le poly-SiGe, beaucoup plus rapidement que le SiGe monocristallin, afin de retirer les couches présentes sur des zones diélectriques.

Selon un mode de réalisation particulier, le mélange comprend un autre précurseur du silicium, tel que du dichlorosilane ou un composé de formule SiₙH₂ₙ₊₂ avec n>1, tel que Si₂H₆, Si₃H₈, ou Si₄H₁₀. L'autre précurseur du silicium représente au maximum 15% volumique par rapport à la somme totale des précurseurs du silicium. Le mélange de précurseurs comporte majoritairement le précurseur hydrogéné. L'ajout d'un autre précurseur du silicium de formule SiₙH₂ₙ₊₂ avec n>1 peut conduire à une modification de la vitesse de croissance du cristal.

De préférence, le mélange de réactifs est constitué par du silane SiH₄, du germane GeH₄, de l'acide chlorhydrique HCl, du diborane B₂H₆.

Le gaz utilisé pour le transport des réactifs est, de préférence du dihdrogène. Selon une variante, de l'azote pourrait être utilisé.

L'épitaxie en présence de silane est, avantageusement, réalisée à une température allant de 580°C à 700°C.

Les épitaxies successives sont, préférentiellement, réalisées à une température inférieure à 700°C, et plus particulièrement à une température allant de 575°C à 675°C. Avantageusement, avec des telles températures, les phénomènes de démouillage, que l'on pourrait observer avec un canal en SiGe contraint de faible épaisseur, sont réduits.

Avec un tel procédé de réalisation, la structure épitaxiale facettée 230a, 230b est exempte de défaut. Il n'y a pas de désorientation dans le matériau cristallin, même au niveau des espaceurs, puisqu'il n'y a pas de contrainte dans le matériau semi-conducteur lors de la croissance cristalline.

Les épitaxies en milieu chloré puis en milieu hydrogéné peuvent être effectuées successivement, et en particulier sans qu'une autre étape intermédiaire de dépôt ou de gravure ne soit effectuée.

Les épitaxies successives en milieu chloré puis en milieu hydrogéné peuvent être effectuées avantageusement mise en œuvre dans un même équipement ou dans un même réacteur, sans que l'on sorte le substrat entre les deux étapes.

En plus d'un gain de temps, lorsque le procédé est réalisé à l'échelle industrielle, cela permet d'obtenir une meilleure de contact, ou de ne pas dégrader la surface de contact, entre la première et la deuxième couche formant les régions de source et de drain surélevées.

De préférence, entre les épitaxies successives réalisées à l'aide de précurseurs différents, une étape de purge de la chambre de dépôt du réacteur ou de l'équipement de dépôt est mise en œuvre.

### Dopage des régions de source/drain :

Préférentiellement, le dopage des régions source/drain surélevées 230a, 230b est réalisé in-situ (présence d'un précurseur du dopant lors de l'épitaxie). Selon une alternative, les étapes de dépôt et de dopage peuvent être dissociées et réalisées successivement.

La première couche 231a, 231b a une concentration en dopant de 7.10¹⁹ à 5.10²¹ at/cm³ pour permettre une diffusion du dopant sous les espaceurs 213 lors du recuit d'activation, tout en gardant un niveau de dopant actif suffisant. Par un niveau de dopant actif suffisant, on entend une concentration en dopant supérieure ou égale à 7.10¹⁹ at/cm³.

La concentration sera ajustée en fonction de l'épaisseur de l'espaceur, du recuit d'activation et de la concentration en germanium.

Avantageusement, la seconde couche 232a, 232b a une concentration en dopant de 2.10²⁰ à 5.10²¹ at/cm³. De telles concentrations permettent une diffusion du dopant suffisante dans la première couche 231a, 231b, si celle-ci est faiblement dopée, par exemple, lorsque l'on souhaite limiter la diffusion sous les espaceurs. Après recuit d'activation/diffusion, la seconde couche 232a, 232b aura, avantageusement, une concentration en dopant supérieure ou égale à 2.10²⁰ at/cm³, de manière à assurer un bon contact sur la partie supérieure de la couche 232a, 232b, par l'intermédiaire du siliciure 240.

La concentration en dopant de la première couche 231a, 231b peut être identique ou différente de la concentration en dopant de la seconde couche 232a, 232b.

Par exemple, les régions de source et drain peuvent être dotées d'une seconde couche 232a, 232b fortement dopée (HDD ou « Heavily Doped source/Drain), avec une concentration en dopant de 5.10²⁰ à 5.10²¹ at/cm³, et d'une première couche 231a, 231b faiblement dopée (LDD ou « Low Doped source/Drain »), avec une concentration en dopant de 7.10¹⁹ à 2.10²⁰ at/cm³ pour ne pas avoir une jonction trop abrupte à l'entrée du canal.

Selon une autre alternative, il peut être intéressant d'avoir une forte concentration (5.10²⁰-5.10²¹ at/cm³) proche de la jonction pour la rendre la plus abrupte possible après le budget thermique du recuit de diffusion/activation, qui a lieu parfois plusieurs étapes après l'épitaxie (« drive-in anneal »).

La concentration en dopant de la première couche 231a, 231b et/ou de la seconde couche 232a, 232b peut être constante, croissante ou décroissante, perpendiculairement à l'épaisseur e₁, e₂ des couches.

Après l'étape de dopage, in situ ou a posteriori, le procédé comprend une étape ultérieure de recuit de diffusion/activation. Cette étape est, avantageusement, réalisée à une température comprise entre 900°C et 1150°C, pendant une durée comprise entre 1s et 60s.

Préférentiellement, le matériau semi-conducteur est du SiGe et le dopant est du bore.

### Exemples illustratifs et non limitatifs pour réaliser une structure épitaxiale facettée en SiGe cristallin :

Dans un premier temps, le substrat en silicium cristallin de type SOI peut être soumis à un budget thermique pour nettoyer la surface du substrat. La température du budget thermique peut aller de 600°C à 900°C, et de préférence de 650°C à 750°C, notamment dans le cas où la couche d'oxyde est très fine.

Les épitaxies chlorée et hydrogénée sont réalisées avec les paramètres du tableau suivant :

| | **Epitaxie Chlorée** | **Epitaxie Hydrogénée** |
|---|---|---|
| **Pression (Torr)** | 10 à 50 | 10 à 50 |
| **Température (°C)** | 600 à 700 | 600 à 700 |
| **HCl (sccm)** | 100 à 400 | 100 à 400 |
| **H₂ (L)** | 15 à 40 | 15 à 40 |
| **SiH₄ (sccm)** | | 100 à 400 |
| **DCS (sccm)** | 100 à 400 | |
| **B₂H₆ (1% dans H₂)** | 40 à 140 | 40 à 140 |
| **GeH₄ (10% dans H₂)** | 80 à 200 | 80 à 200 |

| | | |
|---|---|---|
| sccm correspond à l'unité cm³/min (« standard cubic centimeter per minute »). | | |

Les structures épitaxiales facettées obtenues sont exemptes de défaut cristallin.

## Revendications

1. Transistor à effet de champ, tel qu'un transistor FDSOI, comprenant :
- un substrat 200 recouvert par une couche mince superficielle (203) en un premier matériau semi-conducteur, dans laquelle est formée une région de canal (207) la région de canal étant surmontée par une structure de grille (210), la structure de grille (210) comprenant une grille (211) et des espaceurs (213) isolants tapissant les flancs de la grille,
- une région de source (230a) et une région de drain (230b), situées de part et d'autre des espaceurs (213) isolants, la région de source (230a) et la région de drain (230b) étant formées d'une structure cristalline facettée en un second matériau semi-conducteur cristallin comprenant :
- une première couche (231a, 231b) selon le plan 100, non facettée, en contact avec le premier matériau semi-conducteur de la région de canal (207), la première couche (231a, 231b) comprenant deux faces principales parallèles entre elles et deux faces latérales parallèles entre elles, les faces principales étant perpendiculaires aux faces latérales, une des faces latérales étant en contact avec un des espaceurs (213),
- une seconde couche (232a, 232b) facettée selon le plan 111 recouvrant la première couche (231a, 231b), la seconde couche (232a, 232b) comprenant une première face principale et une seconde face principale parallèles entre elles et deux faces latérales, la première face principale étant en contact avec une face principale supérieure de la première couche (231a, 231b), les faces latérales formant un angle de 50° à 59°, et de préférence de 53°, avec la première face principale,
**caractérisé en ce que** la face principale supérieure de la première couche est entièrement recouverte par, et en contact avec, la première face principale de la seconde couche.

2. Transistor selon la revendication 1, **caractérisé en ce que** le premier matériau semi-conducteur cristallin est du Si ou du SiGe et **en ce que** le second matériau semi-conducteur cristallin est du SiGe.

3. Transistor selon l'une des revendications 1 et 2, **caractérisé en ce que** la première couche (231a, 231b) a une épaisseur comprise entre 2nm et 5 nm, de préférence, entre 2nm et 3nm et/ou **en ce que** la seconde couche (232a, 232b) a une épaisseur comprise entre 5nm et 50 nm, de préférence entre 5nm et 20nm.

4. Transistor selon l'une quelconque des revendications précédentes, **caractérisé en ce que** la première couche (231a, 231b) et la seconde couche (232a, 232b) sont dopées avec un dopant, la première couche (231a, 231b) ayant une concentration en dopant supérieure ou égale à 7.10¹⁹ at/cm³ et la seconde couche (232a, 232b) ayant une concentration en dopant supérieure ou égale à 2.10²⁰at/cm³.

5. Transistor selon l'une quelconque des revendications précédentes, **caractérisé en ce que** la seconde face principale de la seconde couche (232a, 232b) a une longueur supérieure à 10nm et inférieure à 1000nm, et de préférence de 20nm à 50nm.

6. Transistor selon l'une quelconque des revendications précédentes, **caractérisé en ce que** la structure cristalline facettée (230a, 230b) est recouverte d'une couche de siliciure (240), le canal (207) étant isolé de la couche de siliciure (240) par la structure cristalline facettée (230a, 230b).

7. Procédé pour former un transistor à effet de champ comprenant :
- une région de canal (207) en un premier matériau semi-conducteur, surmontée par une structure de grille (210), la structure de grille (210) comprenant une grille (211) et des espaceurs (213) isolants tapissant les flancs de la grille,
- une région de source (230a) et une région de drain (230b), situées de part et d'autre des espaceurs (213) isolants, la région de source et la région de drain étant formées d'une structure cristalline facettée,
le procédé comprenant les étapes successives suivantes :
a) fourniture d'un substrat (200) comprenant une couche mince superficielle (203) en un premier matériau semi-conducteur cristallin,
b) réalisation de la structure facettée (230a, 230b) en un second matériau semi-conducteur cristallin sur le substrat (200) selon les étapes suivantes :
b1) réalisation d'une première couche (231a, 231b) non facettée, sur la couche mince superficielle (203), par épitaxie en présence d'un mélange de réactifs tel qu'il permet une croissance cristalline du second matériau semi-conducteur selon le plan 100, la première couche (231a, 231b) comprenant deux faces principales parallèles entre elles et deux faces latérales parallèles entre elles, les faces principales étant perpendiculaires aux faces latérales, une des faces latérales étant en contact avec un des espaceurs (213),
b2) réalisation d'une seconde couche (232a, 232b) facettée, sur la première couche (231a, 231b), par épitaxie en présence d'un mélange de réactifs tel qu'il permet une croissance cristalline du second matériau semi-conducteur selon le plan 111,
la seconde couche (232a, 232b) comprenant une première face principale et une seconde face principale parallèles entre elles et deux faces latérales, la première face principale étant en contact avec une face principale supérieure de la première couche (231a, 231b).
les faces latérales formant un angle de 50° à 59°, et de préférence de 53°, avec la première face principale,
la face principale supérieure de la première couche (231a, 231b) étant entièrement recouverte et en contact avec la première face principale de la seconde couche (232a, 232b).

8. Procédé selon la revendication 7, **caractérisé en ce que** le mélange de réactifs de la première épitaxie comprend au moins un précurseur chloré du second matériau semi-conducteur et **en ce que** le mélange de réactifs de la seconde épitaxie comprend au moins un précurseur hydrogéné du second matériau semi-conducteur.

9. Procédé selon l'une quelconque des revendications 7 ou 8, **caractérisé en ce que** le premier matériau semi-conducteur cristallin est du Si ou du SiGe et **en ce que** le second matériau semi-conducteur cristallin est du SiGe.

10. Procédé selon l'une des revendications 7 à 9, **caractérisé en ce que** le mélange de réactifs de la première épitaxie comprend du dichlorosilane, du germane, de l'acide chlorhydrique et, éventuellement, du diborane.

11. Procédé selon l'une des revendications 7 à 10, **caractérisé en ce que** le mélange de réactifs de la seconde épitaxie comprend du silane, du germane, de l'acide chlorhydrique, et éventuellement, du diborane.

12. Procédé selon l'une quelconque des revendications 7 à 11, le mélange de réactifs de la seconde épitaxie comprend en outre un composé additionnel choisi parmi le dichlorosilane ou un composé de formule SiₙH₂ₙ₊₂ avec n>1, le composé additionnel représentant au maximum 15% volumique par rapport au volume total formé par le silane et le composé additionnel.

13. Procédé selon l'une quelconque des revendications 7 à 12, **caractérisé en ce que** les épitaxies sont réalisées à une température inférieure à 700°C, et de préférence à une température allant de 575°C à 675°C.

14. Procédé selon l'une quelconque des revendications 7 à 13, **caractérisé en ce que** le procédé est réalisé pour former les régions de source et de drain (230a, 230b) d'un transistor à effet de champ, tel qu'un transistor FDSOI, et plus particulièrement un transistor pMOS.

15. Procédé selon l'une quelconque des revendications 7 à 14, **caractérisé en ce que** la première couche et la deuxième couche sont réalisées par épitaxies successives dans un même réacteur ou un même équipement sans sortir le substrat dudit réacteur ou dudit équipement.

## Patentansprüche

1. Feldeffekttransistor, wie ein FDSOI-Transistor, umfassend:
- ein Substrat 200, das durch eine oberflächliche Dünnschicht (203) aus einem ersten Halbleitermaterial bedeckt ist, in der ein Kanalbereich (207) gebildet ist, wobei der Kanalbereich durch eine Gate-Struktur (210) überbrückt wird, wobei die Gate-Struktur (210) ein Gate (211) und isolierende Abstandhalter (213) umfasst, die die Seiten des Gates auskleiden,
- einen Source-Bereich (230a) und einen Drain-Bereich (230b), die beidseits der isolierenden Abstandhalter (213) angeordnet sind,
wobei der Source-Bereich (230a) und der Drain-Bereich (230b) aus einer facettierten Kristallstruktur und einem zweiten kristallinen Halbleitermaterial gebildet sind, umfassend:
- eine nicht facettierte erste Schicht (231a, 231b) entlang der Ebene 100 im Kontakt mit dem ersten Halbleitermaterial des Kanalbereichs (207), wobei die erste Schicht (231a, 231b) zwei zueinander parallele Hauptflächen und zwei zueinander parallele Seitenflächen umfasst, wobei die Hauptflächen senkrecht zu den Seitenflächen sind, wobei eine der Seitenflächen im Kontakt mit einem der Abstandhalter (213) ist,
- eine facettierte zweite Schicht (232a, 232b) entlang der Ebene 111, die die erste Schicht (231a, 231b) bedeckt, wobei die zweite Schicht (232a, 232b) eine erste Hauptfläche und eine zweite Hauptfläche, die zueinander parallel sind, und zwei Seitenflächen umfasst, wobei die erste Hauptfläche im Kontakt mit einer oberen Hauptfläche der ersten Schicht (231a, 231b) ist, wobei die Seitenflächen einen Winkel von 50° bis 59°, vorzugsweise von 53°, zu der ersten Hauptfläche bilden, **dadurch gekennzeichnet, dass**
die obere Hauptfläche der ersten Schicht vollständig von der ersten Hauptfläche der zweiten Schicht bedeckt wird und mit ihr in Kontakt ist.

2. Transistor nach Anspruch 1, **dadurch gekennzeichnet, dass** das erste kristalline Halbleitermaterial aus Si oder SiGe besteht und dass das zweite kristalline Halbleitermaterial aus SiGe besteht.

3. Transistor nach einem der Ansprüche 1 und 2, **dadurch gekennzeichnet, dass** die erste Schicht (231a, 231b) eine Dicke zwischen 2 nm und 5 nm, vorzugsweise zwischen 2 nm und 3 nm aufweist, und/oder, dass die zweite Schicht (232a, 232b) eine Dicke zwischen 5 nm und 50 nm, vorzugsweise zwischen 5 nm und 20 nm aufweist.

4. Transistor nach einem der vorangehenden Ansprüche, **dadurch gekennzeichnet, dass** die erste Schicht (231a, 231b) und die zweite Schicht (232a, 232b) mit einem Dotiermittel dotiert sind, wobei die erste Schicht (231a, 231b) eine Konzentration des Dotiermittels von größer oder gleich 7,10¹⁹ At/cm³ und die zweite Schicht (232a, 232b) eine Konzentration des Dotiermittels von größer oder gleich 2,1020 At/cm³ aufweist.

5. Transistor nach einem der vorangehenden Ansprüche, **dadurch gekennzeichnet, dass** die zweite Hauptfläche der zweiten Schicht (232a, 232b) eine Länge von über 10 nm und unter 1000 nm, und vorzugsweise von 20 nm bis 50 nm, aufweist.

6. Transistor nach einem der vorangehenden Ansprüche, **dadurch gekennzeichnet, dass** die facettierte Kristallstruktur (230a, 230b) von einer Silizidschicht (240) bedeckt wird, wobei der Kanal (207) durch die facettierte Kristallschicht (230a, 230b) von der Silizidschicht (240) isoliert wird.

7. Verfahren zum Bilden eines Feldeffekttransistors, umfassend:
- einen Kanalbereich (207) aus einem ersten Halbleitermaterial, der durch eine Gate-Struktur (210) überbrückt wird, wobei die Gate-Struktur (210) ein Gate (211) und isolierende Abstandhalter (213) umfasst, die die Seiten des Gates auskleiden,
- einen Source-Bereich (230a) und einen Drain-Bereich (230b), die beidseits der isolierenden Abstandhalter (213) angeordnet sind, wobei der Source-Bereich und der Drain-Bereich aus einer facettierten Kristallstruktur gebildet sind,
wobei das Verfahren die folgenden Schritte umfasst:
a) Bereitstellen eines Substrats (200), das eine oberflächliche Dünnschicht (203) aus einem ersten kristallinen Halbleitermaterial umfasst,
b) Erzeugen der facettierten Struktur (230a, 230b) aus einem zweiten kristallinen Halbleitermaterial auf dem Substrat (200) gemäß den folgenden Schritten:
b1) Erzeugen einer nicht facettierten ersten Schicht (231a, 231b) auf der oberflächlichen Dünnschicht (203) durch epitaktisches Wachstums in Gegenwart einer Mischung von Reagenzien, die ein kristallines Wachstum des zweiten Halbleitermaterials entlang der Ebene 100 ermöglicht, wobei die erste Schicht (231a, 231b) zwei zueinander parallele Hauptflächen und zwei zueinander parallele Seitenflächen umfasst, wobei die Hauptflächen senkrecht zu den Seitenflächen sind, wobei eine der Seitenflächen im Kontakt mit einem der Abstandhalter (213) ist,
b2) Erzeugen einer facettierten zweiten Schicht (232a, 232b) auf der ersten Schicht (231a, 231b) durch epitaktisches Wachstum in Gegenwart einer Mischung von Reagenzien, die ein kristallines Wachstum des zweiten Halbleitermaterials entlang der Ebene 111 ermöglicht,
wobei die zweite Schicht (232a, 232b) eine erste Hauptfläche und eine zweite Hauptfläche, die zueinander parallel sind, und zwei Seitenflächen umfasst, wobei die erste Hauptfläche im Kontakt mit einer oberen Hauptfläche der ersten Schicht (231a, 231b) ist.
wobei die Seitenflächen einen Winkel von 50° bis 59°, und vorzugsweise von 53°, zu der ersten Hauptfläche bilden,
wobei die obere Hauptfläche der ersten Schicht (231a, 231b) vollständig von der ersten Hauptfläche der zweiten Schicht (232a, 232b) bedeckt wird und mit dieser in Kontakt ist.

8. Verfahren nach Anspruch 7, **dadurch gekennzeichnet, dass** die Mischung von Reagenzien des ersten epitaktischen Wachstums mindestens einen chlorierten Vorläufer des zweiten Halbleitermaterials umfasst und dass die Mischung von Reagenzien des zweiten epitaktischen Wachstums mindestens einen hydrogenierten Vorläufer des zweiten Halbleitermaterials umfasst.

9. Verfahren nach einem der Ansprüche 7 oder 8, **dadurch gekennzeichnet, dass** das erste kristalline Halbleitermaterial aus Si oder SiGe besteht und dass das zweite kristalline Halbleitermaterial aus SiGe besteht.

10. Verfahren nach einem der Ansprüche 7 bis 9, **dadurch gekennzeichnet, dass** die Mischung von Reagenzien des ersten epitaktischen Wachstums Dichlorsilan, German, Chlorwasserstoffsäure und eventuell Diboran umfasst.

11. Verfahren nach einem der Ansprüche 7 bis 10, **dadurch gekennzeichnet, dass** die Mischung von Reagenzien des zweiten epitaktischen Wachstums Silan, German, Chlorwasserstoffsäure und eventuell. Diboran umfasst.

12. Verfahren nach einem der Ansprüche 7 bis 11, wobei die Mischung von Reagenzien des zweiten epitaktischen Wachstums ferner eine zusätzliche Zusammensetzung umfasst, ausgewählt aus Dichlorsilan oder einer Zusammensetzung der Formel SiₙH₂ₙ₊₂, mit n>1, wobei die zusätzliche Zusammensetzung maximal 15 % Volumen in Bezug auf das durch das Silan und die zusätzliche Zusammensetzung gebildete Gesamtvolumen darstellt.

13. Verfahren nach einem der Ansprüche 7 bis 12, **dadurch gekennzeichnet, dass** die epitaktischen Wachstümer bei einer Temperatur von unter 700 °C, und vorzugsweise bei einer Temperatur von 575 °C bis 675 °C ausgeführt wird.

14. Verfahren nach einem der Ansprüche 7 bis 13, **dadurch gekennzeichnet, dass** das Verfahren ausgeführt wird, um die Source- und Drain-Bereiche (230a, 230b) eines Feldeffekttransistors, wie eines FDSOI-Transistors, und insbesondere eines pMOS-Transistors, zu bilden.

15. Verfahren nach einem der Ansprüche 7 bis 14, **dadurch gekennzeichnet, dass** die erste Schicht und die zweite Schicht durch aufeinanderfolgende epitaktische Wachstümer in einem selben Reaktor oder in einer selben Anlage erzeug werden, ohne das Substrat aus dem Reaktor oder der Anlage zu nehmen.

## Claims

1. A field-effect transistor, such as an FDSOI transistor, comprising:
- a substrate 200 covered by a thin surface layer (203) made of a first semi-conducting material, in which a channel region (207) is formed, the channel region being overlaid by a gate structure (210), the gate structure (210) comprising a gate (211) and insulating spacers (213) lining the sidewalls of the gate,
- a source region (230a) and a drain region (203b), situated on either side of the insulating spacers (213),
the source region (230a) and the drain region (230b) being formed from a faceted crystalline structure made of a second crystalline semi-conducting material comprising:
- a first layer (231a, 231b) along the plane 100, non-faceted, in contact with the first semi-conducting material of the channel region (207), the first layer (231a, 231b) comprising two main faces parallel to one another and two lateral faces parallel to one another, the main faces being perpendicular to the lateral faces, one of the lateral faces being in contact with one of the spacers (213),
- a second layer (232a, 232b) faceted along the plane 111, overlapping the first layer (231a, 231b), the second layer (232a, 232b) comprising a first main face and a second main face parallel to one another and two lateral faces, the first main face being in contact with an upper main face of the first layer (231a, 231b), the lateral faces forming a 50° to 59° angle, and preferably a 53° angle, with the first main face,
the upper main face of the first layer being entirely overlapped by, and in contact with, the first main face of the second layer
**characterized in that** the upper main face of the first layer is completely covered by and in contact with the first main face of the second layer.

2. The transistor according to claim 1, wherein the first crystalline semi-conducting material is Si or SiGe and in that the second crystalline semi-conducting material is SiGe.

3. The transistor according to either claim 1, **characterized in that** the first layer (231a, 231b) has a thickness that lies in the range 2 nm to 5 nm, preferably in the range 2 nm to 3 nm and/or **characterized in that** the second layer (232a, 232b) has a thickness that lies in the range 5 nm to 50 nm, and preferably in the range 5 nm to 20 nm.

4. The transistor according to any one of preceding claims, **characterized in that** the first layer (231a, 231b) and the second layer (232a, 232b) are doped with a dopant, the first layer (231a, 231b) having a dopant concentration of greater than or equal to 7.10¹⁹ at/cm³ and the second layer (232a, 232b) having a dopant concentration of greater than or equal to 2.10²⁰ at/cm³.

5. The transistor according to any one of preceding claims, **characterized in that** the second main face of the second layer (232a, 232b) has a length that is greater than 10 nm and less than 1,000 nm, and preferably from 20 nm to 50 nm.

6. The transistor according to any one of preceding claims, **characterized in that** the faceted crystalline structure (230a, 230b) is overlapped by a layer of silicide (240), the channel (207) being insulated from the silicide layer (240) by the faceted crystalline structure (230a, 230b).

7. Method for producing a field-effect transistor, comprising:
- a channel region (207) made of a first semi-conducting material, overlaid by a gate structure (210), the gate structure (210) comprising a gate (211) and insulating spacers (213) lining the sidewalls of the gate,
- a source region (230a) and a drain region (203b), situated on either side of the insulating spacers (213), the source region (230a) and the drain region (230b) being formed from a faceted crystalline structure,
the method comprising the following successive steps of:
a) providing a substrate (200) comprising a thin surface layer (203) made of a first crystalline semi-conducting material,
b) producing the faceted structure (230a, 230b) made of a second crystalline semi-conducting material on the substrate (200) according to the steps of:
- producing a first non-faceted layer (231a, 231b), on the thin surface layer (203), by epitaxy in the presence of a mixture of reagents such that it enables the crystalline growth of the second semi-conducting material along the plane 100, the first layer (231a, 231b) comprising two main faces parallel to one another and two lateral faces parallel to one another, the main faces being perpendicular to the lateral faces, one of the lateral faces being in contact with one of the spacers (213),
b2) producing a second faceted layer (232a, 232b), on the first layer (231a, 231b), by epitaxy in the presence of a mixture of reagents such that it enables the crystalline growth of the second semi-conducting material along the crystalline plane 111, the second layer (232a, 232b) comprising a first main face and a second main face parallel to one another and two lateral faces, the first main face being in contact with an upper main face of the first layer (231a, 231b),
the lateral faces forming a 50° to 59° angle, and preferably a 53° angle, with the first main face,
the upper main face of the first layer (231a, 231b) being entirely overlapped by, and in contact with, the first main face of the second layer (232a, 232b).

8. The method according to claim 7, **characterized in that** the mixture of reagents of the first epitaxy comprises at least one chlorinated precursor of the second semi-conducting material and **in that** the mixture of reagents of the second epitaxy comprises at least one hydrogenated precursor of the second semi-conducting material.

9. The method according to one of claim 7 or 8, **characterized in that** the first crystalline semi-conducting material is Si or SiGe and **in that** the second crystalline semi-conducting material is SiGe.

10. The method according to one of claim 7 to 9, **characterized in that** the mixture of reagents of the first epitaxy comprises dichlorosilane, germane, hydrochloric acid and possibly diborane.

11. The method according to one of claim 7 to 10, **characterized in that** the mixture of reagents of the second epitaxy comprises silane, germane, hydrochloric acid and possibly diborane.

12. The method according to one of claim 7 to 11, **characterized in that** the mixture of reagents of the second epitaxy further comprising an additional compound chosen from the group comprised of dichlorosilane or a compound having the formula SiₙH₂ₙ₊₂ where n>1, the additional compound representing 15 vol.% at most relative to the total volume formed by the silane and the additional compound.

13. The method according to one of claim 7 to 12, **characterized in that** the epitaxies take place at a temperature of less than 700°C, and preferably at a temperature in the range 575°C to 675°C.

14. The method according to one of claim 7 to 13, **characterized in that** the method is used to form the source and drain regions (230a, 230b) of a field-effect transistor, such as an FDSOI transistor, and more particularly a pMOS transistor.

15. The method according to one of claim 7 to 14, **characterized in that** the first layer and the second layer are produced by successive epitaxies in the same reactor or in the same equipment, without removing the substrate from said reactor or said equipment.
